# EUROPEAN PATENT APPLICATION

(11) **EP 4 832 345 A1**
(43) Date of publication of application: **28.10.2026**
(21) Application number: 24931095.4
(22) Date of filing: 04.07.2024
(51) Int. Cl.: H02S 50/00, G06T 7/00, G06F 3/14, G01R 31/08, G01R 22/06

(54) **METHOD AND APPARATUS FOR PROVIDING INFORMATION ABOUT PHOTOVOLTAIC POWER GENERATION SYSTEM**

(30) Priority: 21.03.2024 KR 20240039077
(71) Applicant: Hanwha Solutions Corporation, Jung-gu Seoul 04541 (KR)
(72) Inventor: KIM, Kyung Min, Seoul 04541 (KR); KOH, Ga Young, Seoul 04541 (KR); MUN, Chang Yong, Seoul 04541 (KR)
(74) Representative: Mooser, Sebastian Thomas
(86) International application number: PCT/KR2024/009477
(87) International publication number: WO 2025/198097

(57) **Abstract**

An apparatus includes at least one memory; and at least one processor, wherein the at least one processor outputs an initial screen displaying a plurality of devices included in the solar photovoltaic system and a connection relationship between the plurality of devices, acquires power information for each of the plurality of devices, and outputs a screen in which the initial screen is changed so that a transfer of power between the plurality of devices is expressed in real time based on the power information.

## Description

### Technical field

The present disclosure relates to a method and apparatus for providing information on a solar photovoltaic system.

### Background art

### Background art

Recently, as interest in eco-friendly energy technology has increased, solar photovoltaic system facilities have also increased.

When such a solar photovoltaic system is on a large scale, the solar photovoltaic system may be inevitably installed at a long distance from a place where power obtained through solar power generation is used.

In this case, there is an inconvenience of having to travel to the place where the solar photovoltaic system is installed to directly check the amount of power generated by solar power generation, the amount of consumed power, whether a plurality of devices included in the solar photovoltaic system are broken, whether a solar power module is broken, etc.

In the present disclosure, it is intended to provide information on a solar photovoltaic system so that users may remotely acquire various information on the solar photovoltaic system and easily determine a status of the solar photovoltaic system.

### Detailed Description of the Invention

### Technical problems

An object of the present disclosure is to provide a method and apparatus for providing information on a solar photovoltaic system. Another object of the present disclosure is to provide a computer-readable recording medium on which a program for executing the method on a computer is recorded. The technical problems to be solved are not limited to those described above, and other technical problems may exist.

### Technical solution

According to one aspect of the present disclosure, a method for providing information on solar photovoltaic system includes: outputting an initial screen displaying a plurality of devices included in the solar photovoltaic system and a connection relationship between the plurality of devices; acquiring power information for each of the plurality of devices; and outputting a screen in which the initial screen is changed so that a transfer of power between the plurality of devices is expressed in real time based on the power information.

According to another aspect of the present disclosure, an apparatus includes: a memory in which at least one program is stored; and at least one processor executing the at least one program, wherein the at least one processor outputs an initial screen displaying a plurality of devices included in the solar photovoltaic system and a connection relationship between the plurality of devices, acquires power information for each of the plurality of devices, and outputs a screen in which the initial screen is changed so that a transfer of power between the plurality of devices is expressed in real time based on the power information.

According to another aspect of the present disclosure, a computer-readable recording medium includes a recording medium on which a program for executing the method described above in a computer is executed.

### Effects of the Invention

Through the display, a user may remotely check a real-time status and information of various devices included in the solar photovoltaic system.

In addition, the user may easily manage various devices included in the solar photovoltaic system in response to real-time situations of the solar photovoltaic system.

In addition, by providing the user with a screen displaying abnormality of a device included in the solar photovoltaic system, the user may rapidly and effectively respond to the abnormality of the device.

However, the effects of the examples are not limited to the effects mentioned above, and other effects not mentioned will be clearly understood by those skilled in the art from the description of the present disclosure.

### Brief description of drawings

FIG. 1 is a diagram illustrating an example of a method for providing information on a solar photovoltaic system according to an embodiment.
FIG. 2 is a configuration diagram illustrating an example of an apparatus for providing information on a solar photovoltaic system according to an embodiment.
FIG. 3 is a flowchart illustrating an example of a method for providing information on a solar photovoltaic system according to an embodiment.
FIG. 4 is a diagram illustrating an example of an initial screen displaying a connection relationship between a plurality of devices according to an embodiment.
FIG. 5 is a diagram illustrating an example of a method of outputting a screen in which an initial screen is changed according to an embodiment.
FIG. 6 is a diagram illustrating an example of an electric wire that changes in an initial screen according to an embodiment.
FIG. 7 is a diagram illustrating an example of setting a reference point on an electric wire according to an embodiment.
FIG. 8 is a diagram illustrating an example of changing a shape of an image corresponding to an electric wire based on a result of determining that the electric wire is defective, according to an embodiment.
FIG. 9 is a diagram illustrating another example of changing a shape of an image corresponding to an electric wire based on a result of determining that the electric wire is defective according to an embodiment.
FIG. 10 is a diagram illustrating another example of an initial screen displaying a connection relationship of a plurality of devices included in a solar photovoltaic system according to an embodiment.
FIG. 11 is a diagram illustrating an example in which an image corresponding to a cell determined to be defective is displayed differently among images corresponding to a plurality of cells included in a solar module according to an embodiment.
FIG. 12 is a diagram illustrating an example in which a defective solar module is displayed to be different from a normal solar module according to an embodiment.

### Best mode for carrying out the invention

A device according to an aspect includes at least one memory; and at least one processor, wherein the at least one processor is configured to output an initial screen showing a plurality of devices included in the solar photovoltaic system and a connection relationship between the plurality of devices, acquire power information of each of the plurality of devices, and output a screen in which the initial screen is changed so that a transfer of power between the plurality of devices is expressed in real time.

### Mode for invention

The terms used in the embodiments are possibly selected from among currently well-known terms but may vary depending on the cases or intentions of those skilled in the art or on the advent of new technology, etc. In addition, in certain cases, there are terms arbitrarily selected by the applicant, and in this case, the meaning is described in detail in the relevant description. Therefore, terms used in the specification should be defined based on the meaning of the terms and the description throughout the specification, not just the name of the terms.

In the specification, unless explicitly described to the contrary, the word "comprise" or "include" is understood to imply the inclusion of stated constituent elements, not the exclusion of any other constituent elements In addition, the term, such as " ~ unit" or "module," disclosed in the specification indicates a unit for processing at least one function or operation, and this may be implemented by hardware, software, or a combination thereof.

In addition, although the terms "first," "second," etc. used in the specification may be used herein to describe various elements, these elements should not be limited by these terms. These terms are only used to distinguish one element from another.

Hereinafter, the present disclosure is described in detail with reference to the accompanying drawings. However, the embodiments may be implemented in various different forms and are not limited to the examples described herein.

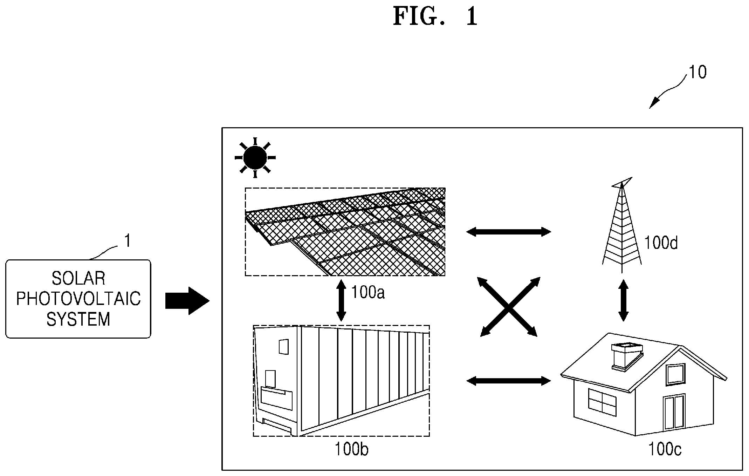

FIG. 1 is a diagram illustrating an example of a method for providing information on a solar photovoltaic system according to an embodiment.

Referring to FIG. 1, information on a plurality of devices 100a, 100b, 100c, and 100d acquired from a solar photovoltaic system 1 may be displayed on a screen 10 and provided to a user.

For example, the information on the plurality of devices 100a, 100b, 100c, and 100d included in the solar photovoltaic system 1 may be acquired. Here, the plurality of devices 100a, 100b, 100c, and 100d may include a solar module 100a, an energy storage system (ESS) 100b, a load 100c, and a grid 100d. However, the devices included in the solar photovoltaic system 1 are not limited thereto.

For example, the solar module 100a may refer to a solar panel that receives solar energy and produces electricity. In addition, the solar module 100a may include a plurality of cells. In addition, the ESS 100b may refer to an energy storage system that stores renewable energy, such as solar energy, to be used when needed. In addition, the load 100c may refer to various types of devices that consume renewable energy. In addition, the grid 100d may refer to a power grid that may optimize energy efficiency by bidirectionally exchanging produced renewable energy.

For example, the grid 100d may acquire information on the solar module 100a, the ESS 100b, the load 100c, and the grid 100d included in the solar photovoltaic system 1 and provide the information to the user. Here, the information may include power information, such as power generation output, temperature, a current amount of power, predicted power consumption, the stored amount of power, the amount of transferred power, and the amount of power consumption and weather information, such as a wind speed, a rainfall, a snowfall, and sunrise/sunset times, but is not limited thereto.

Therefore, the user may acquire information on the solar photovoltaic system 1 remotely even without moving to the place where the solar photovoltaic system 1 is installed. In addition, the user may acquire information on a device which is defective and take measures.

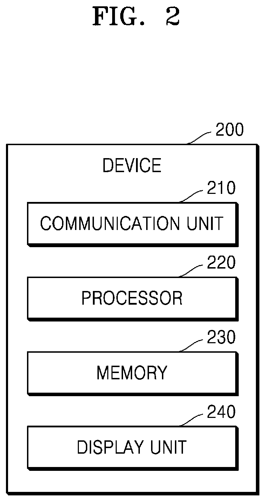

FIG. 2 is a configuration diagram illustrating an example of a device that provides information on a solar photovoltaic system according to an embodiment.

Referring to FIG. 2, a device that provides information on a solar photovoltaic system (hereinafter referred to as 'device') 200 may include a communication unit 210, a processor 220, a memory 230, and a display unit 240. In the device 200 of FIG. 2, only components related to an embodiment are shown. Therefore, it is obvious to those skilled in the art that other general-purpose components may be included in addition to the components shown in FIG. 2.

The communication unit 210 may include one or more components that enable electric wired/electric wireless communication with an external server or external device. For example, the communication unit 210 may include a short-range communication unit (not shown) and a mobile communication unit (not shown) for communication with an external server or external device.

The processor 220 controls an overall operation of the device 200. For example, the processor 220 may generally control an input unit (not shown), a display (not shown), the communication unit 210, the memory 230, etc. by executing programs stored in the memory 230.

The processor 220 may be implemented using at least one of application specific integrated circuits (ASICs), digital signal processors (DSPs), digital signal processing devices (DSPDs), programmable logic devices (PLDs), field programmable gate arrays (FPGAs), controllers, micro-controllers, microprocessors, and other electrical units for performing functions.

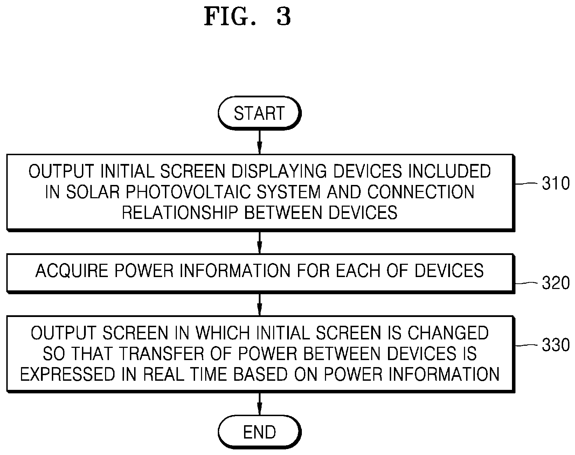

The processor 220 may control the operation of the device 200 by executing programs stored in the memory 230. As an example, the processor 220 may perform at least a portion of the method for providing information on a solar photovoltaic system described above with reference to FIGS. 3 to 12.

The memory 230 is hardware that stores various data processed within the device 200 and may store programs for processing and control of the processor 220.

For example, the memory 230 may store various data, such as power generation output, temperature, a current amount of power, predicted power consumption, the stored amount of power, the amount of transferred power, and the amount of power consumption, weather information, such as a wind speed, a rainfall, a snowfall, and sunrise/sunset times, data generated according to the operation of the processor 220, etc. In addition, an operating system (OS) and at least one program (e.g., a program necessary for the processor 220 to operate, etc.) may be stored in the memory 230.

The memory 230 may include random access memory (RAM), such as dynamic random access memory (DRAM), static random access memory (SRAM), read-only memory (ROM), electrically erasable programmable read-only memory (EEPROM), CD-ROM, Blu-ray or other optical disk storage, a hard disk drive (HDD), a solid state drive (SSD), or flash memory.

The display unit 240 may be hardware that displays various data processed within the device 200.

For example, the display unit 240 may include a smartphone, a tablet PC, a PC, a smart TV, a media player, a navigation device, a kiosk, a wearable device, etc.

Accordingly, the user may acquire prediction information, as well as current and past information, on the solar photovoltaic system through the display unit 240.

FIG. 3 is a flowchart illustrating an example of a method for providing information on a solar photovoltaic system according to an embodiment.

Referring to FIG. 3, the method for providing information on a solar photovoltaic system may include operations 310 to 330. However, the present disclosure is not limited thereto, and other general operations than the operations shown in FIG. 3 may be further included in the method for providing information on the solar photovoltaic system. In addition, as described above with reference to FIGS. 1 and 2, at least one of the operations in the flowchart shown in FIG. 3 may be processed by the processor 220.

In operation 310, the processor 220 may output an initial screen displaying a plurality of devices included in the solar photovoltaic system and the connection relationships between the plurality of devices. Here, the plurality of devices may include at least one solar module, an ESS, at least one load, and a grid.

In operation 320, the processor 220 may acquire power information for each of the plurality of devices. Here, the power information may include power generation output, temperature, a current amount of power, predicted power consumption, the stored amount of power, the amount of transferred power, and the amount of power consumption.

In operation 330, the processor 220 may output a screen in which the initial screen is changed so that the transfer of power between a plurality of devices is expressed in real time based on the power information.

For example, the processor 220 may change a shape of an image corresponding to an electric wire based on the power information so that the transfer of power between devices may be recognized.

Meanwhile, the processor 220 may determine whether at least one of the plurality of devices or electric wires connecting the plurality of devices is defective, and change the shape of an image corresponding to the defective device or electric wire.

As an example, the processor 220 may set at least one reference point on each of the electric wires connecting the plurality of devices based on a preset reference and determine whether at least one of the electric wires is defective based on power information at the at least one reference point. In addition, the processor 220 may change the shape of at least one of the images corresponding to the electric wires on the initial screen in real time based on a determination result and output the at least one changed image.

As another example, the processor 220 may determine whether any one of the plurality of devices is defective based on the power information of each of the plurality of devices, and change the shape of at least one of images corresponding to the plurality of devices in real time on the initial screen based on a determination result and output the at least one changed image. In addition, if it is determined that at least one of the plurality of devices is defective according to the determination result, the processor 220 may output status information of the device determined to be defective.

For example, a device determined to be defective may include at least one of a plurality of cells included in the solar module. In addition, the processor 220 may display and output differently only an image corresponding to at least one cell determined to be defective among the images corresponding to the plurality of cells included in the solar module.

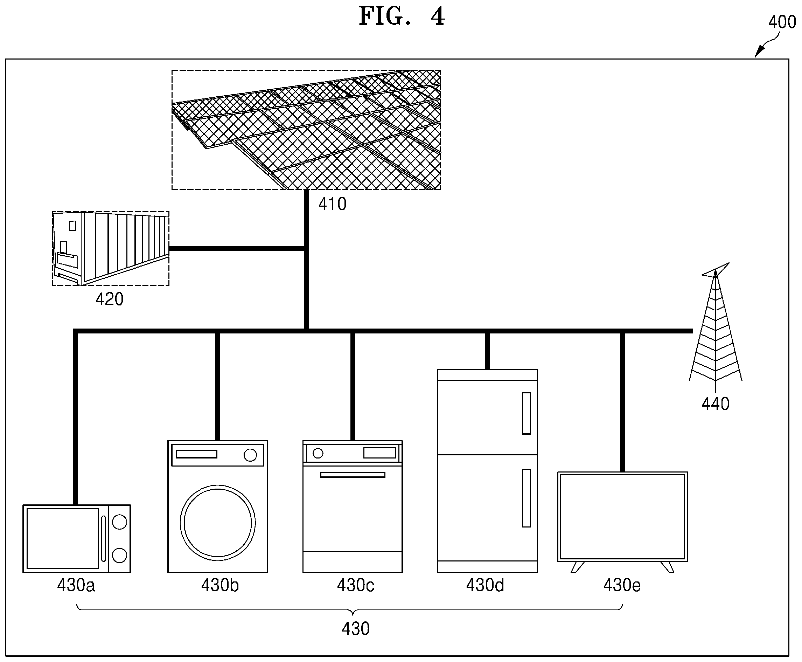

FIG. 4 is a diagram illustrating an example of an initial screen displaying a connection relationship between a plurality of devices according to an embodiment.

Hereinafter, an example in which the processor 220 outputs an initial screen displaying a connection relationship of a plurality of devices is described with reference to FIG. 4.

Referring to FIG. 4, the processor 220 may output an initial screen 400 displaying a connection relationship of the plurality of devices.

For example, the processor 220 may output the initial screen 400 displaying a relationship among a solar module 410, an ESS 429, loads 430, and a grid 440.

Here, the loads 430 may refer to devices that consume power, and although only home appliances are shown in the drawing, the loads 430 are not limited thereto and may include any equipment, device, or part that consumes power.

For example, in the case of a home, the processor 220 may output an initial screen including the loads 430, such as a microwave oven 430a, a washing machine 430b, an oven 430c, a refrigerator 430d, and a TV 430e. In addition, in the case of a factory, the processor 220 may output an initial screen including industrial equipment, machines, etc. In addition, in the case of a farm, the processor 220 may output an initial screen 400 including agricultural equipment, agricultural machinery, etc.

In addition, the processor 220 may represent a connection relationship between a plurality of devices using arbitrary line segments. Here, an arbitrary line segment may correspond to an actual electric wire to which a plurality of devices are actually connected.

For example, the processor 220 may acquire power information for each of the plurality of devices.

For example, the processor 220 may acquire power information of the solar module 410. In detail, the processor 220 may acquire information, such as the current amount of generated power, the accumulated amount of generated power, and the expected amount of generated power of the solar module 410. In addition, the processor 220 may acquire information, such as the current amount of generated power, the accumulated amount of generated power, and the expected amount of generated power of each of the plurality of cells included in the solar module 410.

For example, the processor 220 may acquire power information of the ESS 420. In detail, the processor 220 may acquire information, such as the amount of power stored in the ESS 420 and the expected amount of stored power.

For example, the processor 220 may acquire power information of the loads 430. In detail, the processor 220 may acquire information, such as the amount of power consumption according to an operation of each load 430.

For example, the processor 220 may acquire power information of the grid 440. In detail, the processor 220 may acquire information, such as an amount of power available for transmission and a required amount of power to be received by the grid 440.

For example, the processor 220 may output a screen in which the initial screen 400 is changed so that the transfer of power between the plurality of devices is expressed in real time based on the power information.

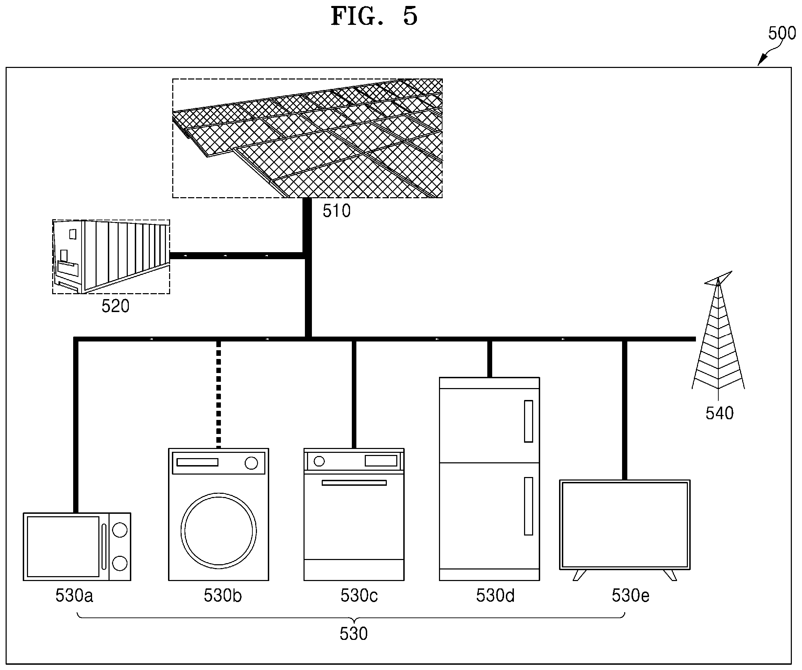

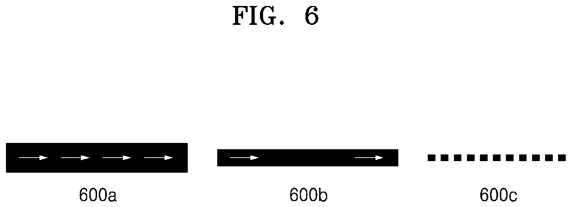

FIG. 5 is a diagram illustrating an example of a method of outputting a screen in which an initial screen is changed initial screen according to an embodiment. FIG. 6 is a diagram illustrating an example of an electric wire that changes in an initial screen according to an embodiment.

Hereinafter, an example in which the processor 220 outputs a screen in which an initial screen is changed, will be described with reference to FIGS. 5 and 6.

First, referring to FIG. 5, the processor 220 may output a screen in which an initial screen is changed so that the transfer of power between a plurality of devices is expressed in real time based on the amount of transferred power.

For example, the processor 220 may express a thickness of the electric wire as thick as the amount of transferred power increases, and express the thickness of the electric wire as thin as the amount of transferred power decreases. In other words, the processor 220 may output a screen 500 by changing the thickness of the electric wire in proportion to the actual amount of transferred power.

In addition, in the present disclosure, the large and small amounts of power may refer to relatively expressing the amount of power of each of the plurality of devices output on the screen 500.

For example, the processor 220 may change the thickness of the electric wire to the thickest because the amount of power transferred from the solar module 510 is the largest. In addition, the processor 220 may change the thickness of the electric wire as a portion of the power transferred from the solar module 510 moves to the ESS 520 and the remaining portion moves to the loads 530 or the grid 540.

For example, the amount of power consumed by each of the loads 530 may be different, and accordingly, the amount of transferred power may also be different, so the processor 220 may change the thickness of electric wire to be different depending on the amount of power moving to each of the loads 530. In addition, if there is a load 530b that does not consume power, among the loads 530, there may be no moving power, so the processor 220 may represent the electric wire the dashed line.

For example, the processor 220 may display the direction of moving power using the arrow. In addition, the processor 220 may change the number of arrows, the spacing between the arrows, the size of the arrows, etc. depending on the amount of transferred power.

For example, the processor 220 may change the number of arrows to increase, the spacing between the arrows to decrease, and the size of the arrows to increase as the amount of transferred power increases.

Referring to FIG. 6, the processor 220 may change the electric wire based on the amount of transferred power.

For example, the processor 220 may change a thickness of an electric wire 600a, which has a relatively large amount of transferred power, to be thicker than that of an electric wire 600b, which has a relatively small amount of transferred power, and may also change even the number of arrows, the spacing between the arrows, the size of the arrows. In addition, the processor 220 may change an electric wire 600c with no transferred power to the dashed line.

Meanwhile, the processor 220 may detect an electric wire in which an error has occurred, change a shape of the electric wire in which the error has occurred, and output the same.

For example, the processor 220 may set at least one reference point on each of the electric wires connecting a plurality of devices based on a preset reference and determine whether at least one of the electric wires is defective based on power information at the at least one reference point. In addition, the processor 220 may change a shape of at least one of images corresponding to the electric wires on the initial screen in real time based on a determination result and output the at least one changed image.

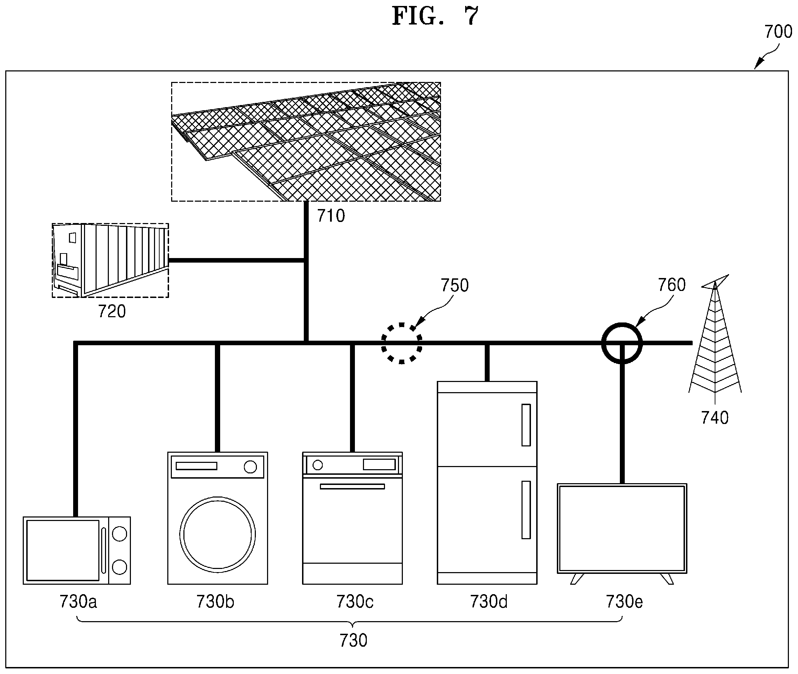

FIG. 7 is a diagram illustrating an example of setting a reference point on an electric wire according to an embodiment.

Hereinafter, an example in which the processor 220 determines which electric wire is defective by setting a reference point on the electric wire will be described.

Referring to FIG. 7, the processor 220 may set at least one of a first reference point 750 or a second reference point 760.

For example, the processor 220 may set a point on at least one of the electric wires connecting a plurality of devices as the first reference point 750. In addition, the processor 220 may set a branch point of the electric wires connecting the plurality of devices as the second reference point 760. Here, the first reference point 750 may be at least one point between the second reference points 760. In addition, for convenience of description, only one first reference point 750 and one second reference point 760 are shown in FIG. 7, but it is obvious to those skilled in the art that a plurality of reference points are set.

For example, the processor 220 may determine whether at least one of the electric wires is defective based on the power information at least one reference point.

For example, the processor 220 may determine whether the electric wire is defective based on the amount of power at the reference point.

For example, if the current amount of power at the reference point is less than the expected amount of power, the processor 220 may determine that the electric wire is defective. In other words, the power produced by the solar module 710 may be stored in the ESS 720 or consumed by the loads 730, so that the amount of power may gradually decrease, and the processor 220 may calculate the expected amount of power at each reference point.

For example, the processor 220 may calculate the expected amount of power at each reference point based on the amount of power produced by the solar module 710, the amount of power stored in the ESS 720, and the amount of power consumed by each of the loads 730. In this case, the processor 220 may set an error range for the expected amount of power based on resistance of the electric wire, weather information, etc.

As an example, the processor 220 may determine that the electric wire is defective when the current amount of power transferred from the reference point is less than the calculated expected amount of power or when the current amount of power is outside the error range of the expected amount of power. As another example, the processor 220 may determine that the electric wire is not defective if the current amount of power transferred from the reference point is within the error range of the expected amount of power.

In addition, the processor 220 may determine that the electric wire is defective even when the amount of power is not measured at the reference point.

For example, the processor 220 may change the shape of at least one of the images corresponding to the electric wires on the initial screen in real time based on the result of determining that the electric wire is defective and outputs the at least one changed image. Here, a defective electric wire may refer to a problem, such as a cut electric wire, an electrical short, or short circuit, in the electric wire. In addition, changing the image corresponding to the electric wire may include changing the color of the electric wire, adding a new mark to the electric wire, dividing one electric wire into a plurality of electric wires, etc.

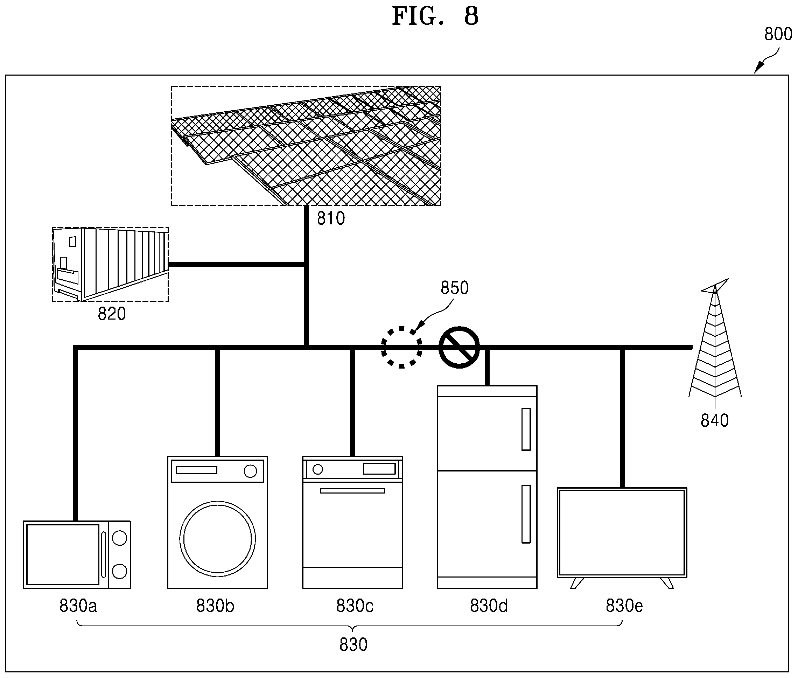

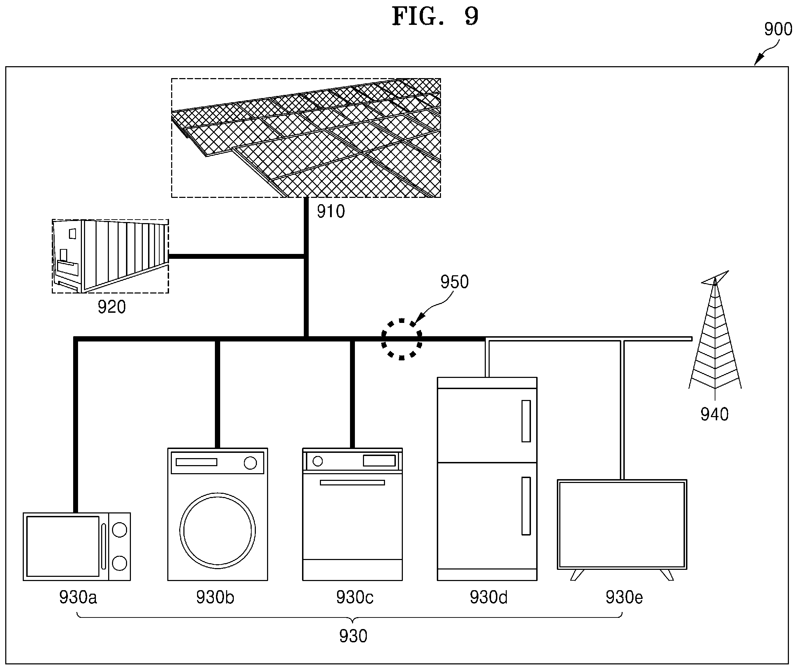

FIG. 8 is a diagram illustrating an example of changing a shape of an image corresponding to a wire based on a result of determining that the wire is abnormal, according to an embodiment. FIG. 9 is a diagram illustrating another example of changing a shape of an image corresponding to a wire based on a result of determining that the wire is abnormal according to an embodiment.

Hereinafter, examples in which the processor 220 changes the shape of an image corresponding to an electric wire is described with reference to FIGS. 8 and 9.

First, referring to FIG. 8, if it is determined that the electric wire is defective based on the power information at a reference point 850, the processor 220 may may display that the corresponding electric wire is defective.

For example, the processor 220 may output a screen 800 in which a new image is added to an image corresponding to the electric wire determined to be defective.

For example, the processor 220 may output the screen 800 having a shape in which the electric wire is broken, changed from an image corresponding to the electric wire determined to be defective.

In addition, the processor 220 may provide the user with a notification that the electric wire is defective, and also provide information on the defective electric wire. For example, the processor 220 may provide the user with information, such as a position of the defective electric wire, the reason for determining the defect, the current amount of power of the electric wire, and the expected amount of power of the electric wire.

Referring to FIG. 9, if the amount of power at a reference point 950 is less than a preset value, the processor 220 may determine that the electric wire in which the reference point 950 exists is defective and output a screen 900 changed in the shape of an image corresponding to electric wires after the corresponding electric wire.

For example, the processor 220 may determine that the electric wire is broken when the amount of power at the reference point 950 is less than a preset value. Accordingly, the processor 220 may output the screen 900 changed in the shape of an image corresponding to electric wires in which power cannot be transferred due to the broken electric wire.

For example, the processor 220 may determine that the corresponding electric wire is defective based on the power information at the reference point 950 and change the shape of the image corresponding to the electric wires to a refrigerator 930d, a TV 930e, and a grid 940 to which power cannot be transferred in real time and output the changed image.

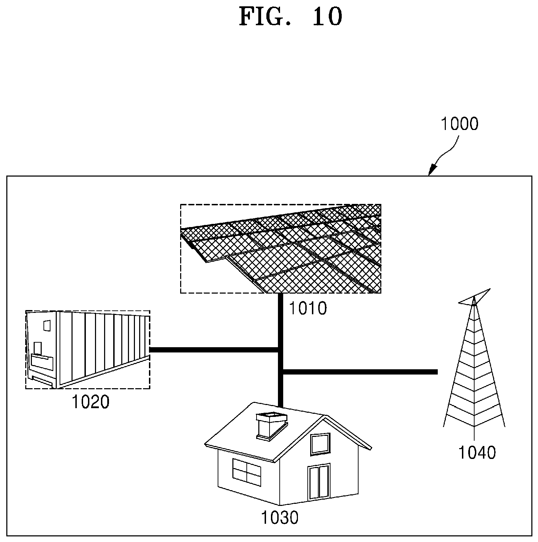

FIG. 10 is a diagram illustrating another example of an initial screen displaying a connection relationship between a plurality of devices included in a solar photovoltaic system according to an embodiment.

Hereinafter, another example in which the processor 220 outputs an initial screen displaying a connection relationship between a plurality of devices is described with reference to FIG. 10.

Referring to FIG. 10, the processor 220 may output an initial screen 1000 displaying a connection relationship between a plurality of devices.

For example, the processor 220 may output the initial screen 1000 displaying a connection relationship between a solar module 1010, an ESS 1020, a load 1030, and a grid 1040.

In addition, the processor 220 may detect a defective device based on power information and output a screen changed in the shape of an image corresponding to the detected defective device.

For example, the processor 220 may determine whether any one of the plurality of devices is defective based on the power information of each of the plurality of devices and change the shape of at least one of images corresponding to the plurality of devices in real time in the initial screen based on a determination result and output the at least one changed image.

In addition, if it is determined that at least one of the plurality of devices is defective according to the determination result, the processor 220 may output status information of the device determined to be defective.

For example, the processor 220 may determine that the solar module 1010 is defective using a difference between the expected amount of power generated by the solar module 1010 and the actual amount of power transferred from the solar module 1010. In other words, the processor 220 may determine that the solar module 1010 is defective when the difference between the expected amount of power generated by the solar module 1010 and the actual amount of generated power is outside a preset range. Here, the preset range may be -50% to +50% of the expected amount of generated power, but is not limited thereto.

In addition, the processor 220 may determine that the ESS 1020 is defective using an expected amount of stored power and an actual amount of stored power of the ESS 1020. In other words, the processor 220 may determine that the ESS 1020 is defective if the difference between the expected amount of stored power and the actual amount of stored power of the ESS 1020 is outside a preset range. Here, the preset range may be -50% to +50% of the expected the stored amount of power, but is not limited thereto.

In addition, the processor 220 may determine that the load 1030 is defective using an average amount of power consumption and a current amount of power consumption of the load 1030. In other words, the processor 220 may determine that the load 1030 is defective if the difference between the average amount of power consumption and the current amount of power consumption of the load 1030 is outside a preset range. Here, the average amount of power consumption may be an average amount of power consumption for 3, 7, or 30 days based on the present, but is not limited to this and may be set to vary depending on a user selection. Here, the preset range may be -50% to +50% of the average amount of power consumption, but is not limited thereto.

In addition, the processor 220 may determine that the grid 1040 is defective using the expected amount of transmitted and received power and the actual amount of transmitted and received power of the grid 1040. In other words, the processor 220 may determine that the grid 1040 is defective when a difference between an expected amount of transmitted and received power and an actual amount of transmitted and received power is outside a preset range. Here, the preset range may be -50% to +50% of the expected transmitted and received power amount, but is not limited thereto.

For example, the processor 220 may output a screen changed in a shape of an image corresponding to a device determined to be defective. In detail, the processor 220 may output a screen obtained by adding an indication that a defect has occurred in to the shape of the image corresponding to the device determined to be defective. In addition, the processor 220 may provide a notification, such as sound and text to the user.

For example, if it is determined that at least one of the plurality of devices is defective according to the determination result, the processor 220 may output status information of the device determined to be defective.

For example, the processor 220 may output power information of a device determined to be defective together. In detail, if the solar module 1010 is defective, the processor 220 may provide the user with a screen on which information on the expected amount of generated power and information on the actual amount of generated power are output together when the solar module 1010 is defective, a screen on which information on the expected amount of stored power and information on the actual amount of stored power are output together when the ESS 1020 is defective, a screen on which information on the average amount of power consumption and information on the current amount of power consumption are output together when the load 1030 is defective, and a screen on which information on the expected amount of transmitted and received power and information on the actual amount of transmitted and received power are output together when the grid 1040 is defective.

In addition, the device determined to be defective may include at least one of a plurality of cells included in the solar module.

For example, the processor 220 may display and output differently only an image corresponding to at least one cell determined to be defective among images corresponding to a plurality of cells included in the solar module.

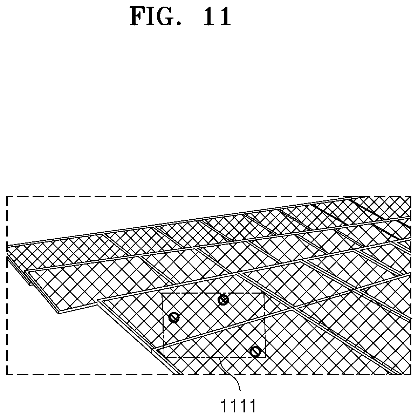

FIG. 11 is a diagram illustrating an example in which an image corresponding to a cell determined to be defective is displayed to be different, among images corresponding to a plurality of cells included in a solar module according to an embodiment of the present disclosure.

Hereinafter, an example in which the processor 220 displays images corresponding to a plurality of cells included in a solar module is described with reference to FIG. 11.

Referring to FIG. 11, the processor 220 may detect a defective cell 1111 among cells included in the solar module.

For example, the processor 220 may detect a defective cell 1111 using a difference between the expected amount of generated power and the actual amount of generated power for each of the plurality of cells included in the solar module.

Thus, the processor 220 may output a screen 1110 in which only the image corresponding to the defective cell 1111 is displayed to be different.

As an example, the processor 220 may add an indication that the image corresponding to the defective cell 1111 is defective. As another example, the processor 220 may change a color of the image corresponding to the defective cell 1111.

As an additional example, the processor 220 may determine whether there is foreign matter in the solar module or a cell and detect a defective cell 1111 due to the foreign matter.

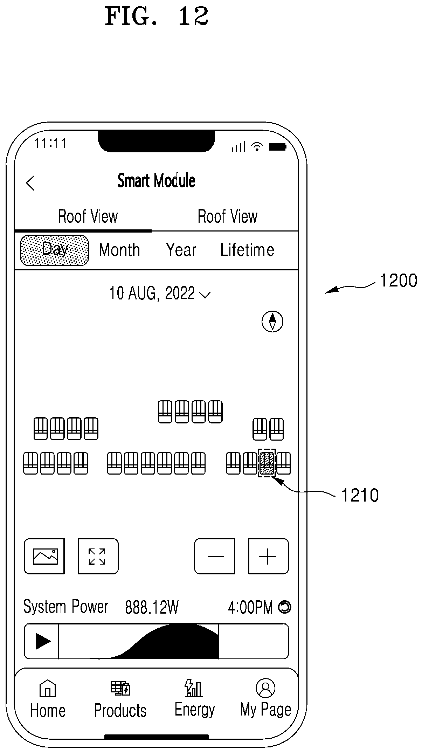

FIG. 12 is a diagram illustrating an example in which a defective solar module is displayed to be different from a normal solar module according to an embodiment.

Hereinafter, an example of displaying an image of a defective solar module is described with reference to FIG. 12.

Referring to FIG. 12, the processor 220 may provide a screen 1200 including a plurality of solar modules.

For example, the processor 220 may provide the user with a screen 1200 on which an image of a plurality of solar modules is displayed. In addition, the processor 220 may display an image 1210 of a solar module determined to be defective among the plurality of solar modules differently from the other solar modules and provide the image to the user.

For example, the processor 220 may detect a defective solar module using a difference between the expected amount of generated power and the actual amount of generated power of the solar module.

Accordingly, the processor 220 may display only the image 1210 of the defective solar module differently among the images of the plurality of solar modules.

As an example, the processor 220 may add an indication that there is a defect in the image 1210 of the solar module. As another example, the processor 220 may change the color of the image 1210 of the defective solar module.

Meanwhile, the aforementioned method may be written as a program that may be executed on a computer and may be implemented in a general-purpose digital computer that operates the program using a computer-readable recording medium. In addition, a data structure used in the aforementioned method may be recorded on a computer-readable recording medium through various units. The computer-readable recording medium includes a storage medium, such as magnetic storage mediums (e.g., ROM, RAM, USB, floppy disk, hard disk, etc.) and optical reading mediums (e.g., CD-ROM, DVD, etc.).

Those skilled in the art related to the present embodiment will understand that the present disclosure may be implemented in a modified form without departing from the essential characteristics. Therefore, the disclosed methods should be considered from an explanatory rather than a limiting perspective, and the scope of the present disclosure is indicated in the claims, not the foregoing description, and should be interpreted to include all differences within the equivalent scope.

## Claims

1. A method for providing information on solar photovoltaic system, the method comprising:
outputting an initial screen displaying a plurality of devices included in the solar photovoltaic system and a connection relationship between the plurality of devices;
acquiring power information for each of the plurality of devices; and
outputting a screen in which the initial screen is changed so that a transfer of power between the plurality of devices is expressed in real time based on the power information.

2. The method of claim 1, further comprising:
setting at least one reference point on each of electric wires connecting the plurality of devices based on a preset reference;
determining whether at least one of the electric wires is defective based on power information at the at least one reference point; and
changing in real time a shape of at least one of images corresponding to the electric wires on the initial screen based on a determination result and outputting the at least one changed image.

3. The method of claim 1, further comprising:
determining whether any one of the plurality of devices is defective based on the power information of each of the plurality of devices; and
changing in real time a shape of at least one of images corresponding to the plurality of devices on the initial screen based on a determination result and outputting the at least one changed image.

4. The method of claim 3, wherein
outputting, when it is determined that at least one of the plurality of devices is defective according to the determination result, status information of the device determined to be defective.

5. The method of claim 3, wherein
the device determined to be defective includes at least one solar module.

6. The method of claim 5, wherein,
in the outputting,
displaying and outputting differently only an image corresponding to at least one cell determined to be defective among images corresponding to a plurality of cells included in the at least one solar module.

7. The method of claim 1, wherein
the plurality of devices include at least one solar module, an energy storage system (ESS), at least one load, and a grid.

8. A computer-readable recording medium having recorded a program to
cause the method of claim 1 to be executed on a computer.

9. An apparatus for providing information on a solar photovoltaic system,
the apparatus comprising:
a memory storing at least one program; and
at least one processor configured to execute the at least one program, wherein the at least one processor is further configured to
outputs an initial screen displaying a plurality of devices included in the solar photovoltaic system and a connection relationship between the plurality of devices,
acquire power information for each of the plurality of devices, and
output a screen in which the initial screen is changed so that a transfer of power between the plurality of devices is expressed in real time based on the power information.

10. The apparatus of claim 9, wherein
the at least one processor is further configured to
set at least one reference point on each of electric wires connecting the plurality of devices based on a preset reference,
determine whether at least one of the electric wires is defective based on power information at the at least one reference point, and
change in real time a shape of at least one of images corresponding to the electric wires on the initial screen based on a determination result and output the at least one changed image.

11. The apparatus of claim 9, wherein
the at least one processor is further configured to
determine whether any one of the plurality of devices is defective based on the power information of each of the plurality of devices, and
change in real time a shape of at least one of images corresponding to the plurality of devices on the initial screen based on a determination result and output the at least one changed image.

12. The apparatus of claim 11, wherein
the at least one processor is further configured to
output, when it is determined that at least one of the plurality of devices is defective according to the determination result, status information of the device determined to be defective.

13. The apparatus of claim 11, wherein
the device determined to be defective includes at least one solar module.

14. The apparatus of claim 13, wherein
the at least one processor is further configured to
display and output differently only an image corresponding to at least one cell determined to be defective among images corresponding to a plurality of cells included in the at least one solar module.

15. The apparatus of claim 9, wherein
the plurality of devices include at least one solar module, an energy storage system (ESS), at least one load, and a grid.
